Europäisches Patentamt

(19) European Patent Office

Office européen des brevets

(11) Publication number: **0 068 306**
**B1**

(12) **EUROPEAN PATENT SPECIFICATION**

(45) Date of publication of patent specification: **15.01.86**

(51) Int. Cl.⁴: **H 02 P 8/00**

(21) Application number: **82105274.3**

(22) Date of filing: **16.06.82**

(54) Step motor drive circuit.

(30) Priority: **23.06.81 IT 2250281**

(43) Date of publication of application:
**05.01.83 Bulletin 83/01**

(45) Publication of the grant of the patent:
**15.01.86 Bulletin 86/03**

(84) Designated Contracting States:
**DE FR GB**

(56) References cited:
**EP-A-0 019 471**
**EP-A-0 054 826**
**DE-A-2 927 809**
**DE-B-2 916 105**
**FR-A-2 388 436**
**US-A-4 061 931**
**US-A-4 107 593**

**PATENTS ABSTRACTS OF JAPAN, vol. 5, no.
63, 28th April 1981, page E54-735**

(73) Proprietor: **HONEYWELL INFORMATION
SYSTEMS ITALIA S.p.A.
Via Martiri d'Italia 3
I-10014 Caluso (Torino) (IT)**

(72) Inventor: **Fare, Carlo
Via Dante 116
I-20090 Limito (MI) (IT)**

Courier Press, Leamington Spa, England.

## Description

The present invention relates to drive circuits for step motors. As known, a step motor comprises a rotor, constituted for example by a permanent magnet with toothed pole pieces, and by a toothed stator provided with phase windings which, when energized, induce magnetic fields in the stator.

Each phase windings is connected on one hand to a D.C. voltage source and on the other one to a switching device (generally a power switch transistor) such device, suitably switched on, allows an energizing current to flow through the winding.

When the phase windings of a stepping motor are energized according to a suitable sequence, the magnetic fields induced in the stator interact with the rotor causing its rotation; in particular the rotor is fed with an angle corresponding to a step for each current switching in the windings.

At present, in order to improve the stepping motor performances, the so called current chopping control systems are used; such "chopping" systems maintaining the energization current in the phase windings to pre-established values during all the energization time of such phase windings.

Substantially, the "chopping" systems intermittently feed the phase windings. In other words they switch off the feeding current when it reaches a prefixed value, allow the so established current to flow through a recirculating path and to decay with a time constant determined by the electrical features of the recirculating path, switch on again the feeding current after a predetermined time interval or when the circulating current is decayed to a second prefixed value, and so on for the whole energization time of the phases.

Examples of such systems are given by U.S. Patents No. 4,107,593 and No. 3,813,413.

A limit to the chopping frequency, according to which the energized windings are connected to and disconnected from the voltage source, is determined by operational limitations of the power transistors when used as switch devices.

In fact such transistors, which are controlled to work in the extreme conditions of cutoff and saturation, do not switch immediately from a working condition to the other one, but they respond to the applied control signals with some delay time. Particularly the most critical situation occurs when a transistor switches from the saturation condition (ON) to the cutoff one (OFF).

In such case the saturation current falls near to zero with a relatively long delay time especially determined by to so-called storage time, that is by the time necessary for removing the minority carriers from the base.

It follows that, for a time interval proportional to the storage time, the transistor works in conditions of high collector-emitter voltage drop and, at the same time, is crossed by a high current. This involves for a switching transistor, during the switching from ON to OFF, a considerable peak of absorbed power.

For high switching frequencies, for example, above the acoustic frequencies, a current chopping control system, besides requiring the use of switching transistors with high dissipable power (therefore very expensive), also involves a degradation of the stepping motor efficiency. A solution of the problem is that one of removing the main cause of the switching losses, that is of removing, or at least reducing, the storage time of a power switch transistor during the switching from ON to OFF.

A method known in the art, for reducing the storage time of a transistor, consists in applying a reverse voltage to the base of the switch transistor so as to speed up the removal of the minority carriers from the base.

But such method, besides presupposing the use of both positive and negative voltages in the stepping motor drive circuit with consequent complexity increase of the power supply, also involves a high level for the control signals applied to the transistors and therefore more expensive drive logic circuits.

If a transistor drives an inductive load, the reverse voltage for speeding up its turn off can be obtained by using an auxiliary winding magnetically coupled in phase opposition to the winding of the inductive load. Such type of transformer-coupled configuration has been proposed in US Patent No. 4,061,931 to obtain, through a suitable feedback circuit comprising a capacitor, a reverse voltage pulse to be applied to the base of the transistor of a switching voltage regulator.

The adoption of such a concept in step motor driving could be considered but would lead to the design of step motors where each phase is provided with a magnetically coupled auxiliary winding, in transformer like fashion, the auxiliary winding providing reverse voltage pulses which may be used to speed up the switching off of control transistors. The addition of auxiliary windings would lead to constructive complications and additional costs.

The drive circuit of a stepping motor of the present invention avoids these disadvantages and allows to reduce to a minimum in a simple and unexpensive way the storage time of the switching transistors.

So for a determinate chopping frequency, the drive circuit of the invention, besides improving the stepping motor efficiency, also allows to use less expensive switching transistors.

The present invention, as defined by claim 1, avoids auxiliary windings by exploiting the high magnetic coupling of those pairs of stator windings which are geometrically and electrically in phase opposition. During the current chopping in an energized phase winding, and more particularly next to the switching command which leads from ON condition to OFF condition the transistor associated to such energized phase winding, the electromotive force arising into the phase winding magnetically coupled to the one under examination is used to apply a reverse voltage to the base of the switching transistor associated to the energization phase winding; in such way a fast transition of such transistor towards the cutoff region is obtained.

These and other features will appear more clearly from the following description of a preferred embodiment of the invention and from the enclosed drawings where:

Fig. 1 shows the drive circuit for a four phase stepping motor object of the invention;

Fig. 2 shows the wave forms (current or voltage) in particular points of the drive circuit of fig. 1;

Fig. 3 shows a simplified drive circuit to the one of fig. 1;

Fig. 4 shows a switch device utilizable in the drive circuit of fig. 1.

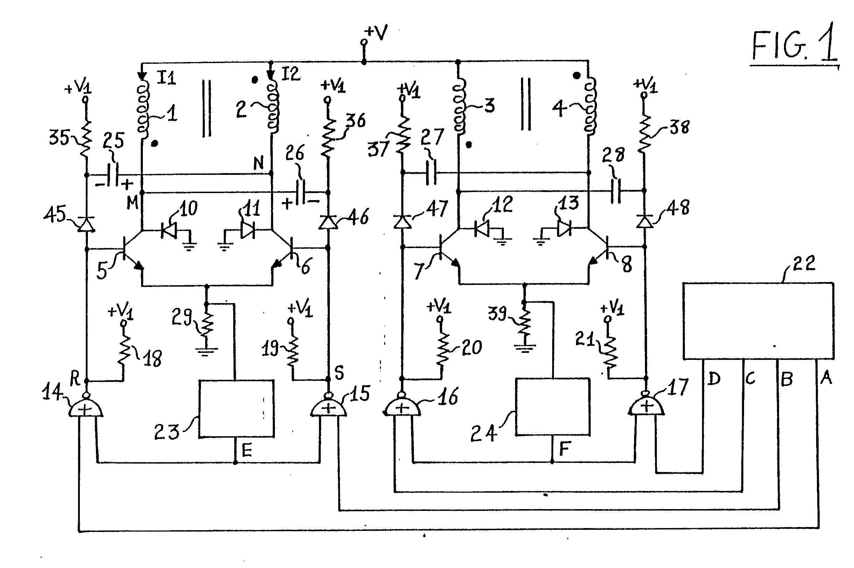

Referring to fig. 1, it shows the drive circuit of windings 1, 2, 3, 4 of a four phase stepping motor.

Phase windings 1, 2 and phase windings 3, 4 are magnetically coupled between them.

A terminal of windings 1, 2, 3, 4 is connected to a supply source of continue voltage +V.

The other terminal of windings 1, 2, 3, 4 is connected to the collector of four switching transistors 5, 6, 7, 8 respectively.

The emitters of transistors 5, 6 are connected to ground through a resistor 29 with a low resistance value, for instance 0.5Ω. In similar way the emitters of transistors 7, 8 are connected to ground through a resistor 39 of resistance value equal to the one of resistor 29.

A recycle and demagnetization diode 10, 11, 12, 13 is respectively connected to the collector of transistors 5, 6, 7, 8; the anodes of diodes 10, 11, 12, 13 are connected to ground.

When the current in phase winding 1 (such current flowing from voltage source +V to ground) is switched off owing to the cutoff of transistor 5, the magnetic coupling between phase winding 1, 2 induces in phase winding 2 an electromotive force and a recycle current flowing from ground to voltage source +V through diode 11.

The function of the other diodes is similar.

The bases of transistors 5, 6, 7, 8 are respectively connected to the outputs of two-input NOR gates 14, 15, 16, 17 of "open collector" type and to a source of DC voltage +V1, having suitable value, through resistors 18, 19, 20, 21.

A control signal A, B, C, D coming from a suitable control unit 22 is applied to a first input of NOR gate 14, 15, 16, 17 respectively. The description of control unit 22 is omitted because such unit is beyond the scope of the invention and the possible embodiments of it are well known to the people skilled in the art.

The function of control unit 22 is to generate signals A, B, C, D in suitable sequence so as to control the motor to work according to a desired way.

In the described embodiment example the energization sequence occurs for phase couples so as to increase the stepping motor efficiency, as it is well known to the people skilled in the art.

In order to obtain the several operative conditions of motor motion, the couple formation of contemporaneously energized windings occurs according to so-called Gray code, where each couple differs from the previous one only for a winding.

It is clear that the pairs of magnetically coupled phase windings can be never energized at the same time, otherwise the resulting torque acting on the rotor would be null.

For clearness purposes, referring to fig. 1, it may be for example supposed that, in order to obtain a motion in clockwise direction of the rotor of the stepping motor, the energization sequence has to be: energization of phases 1 and 3 (signals A, C at logical level 0 and signals B, D at logical level 1), energization of phases 2 and 3 (signals B, C at logical level 0 and signals A, D at logical level 1), energization of phases 2 and 4 (signal B, D at logical level 0 and signal A, C at logical level 1), energization of phases 1 and 4 (signals A, D at logical level 0 and signal B, C at logical level 1), and so on.

It is clear that a motion in counterclockwise direction of the rotor is obtained by reversing the energization sequence of the phases that is: energization of phases 1 and 4, energization of phases 2 and 4, energization of phases 2 and 3, energization of phases 1 and 3, energization of phases 1 and 4, and so on.

On the second inputs of NOR gates 14, 15 a further control signal E is applied. Signal E is generated by a current control circuit 23. In similar way on the second inputs of NOR gates 16, 17 a further control signal F is applied. Signal F is generated by a current control circuit 24.

Control circuit 23 receives on its input, connected to terminal of resistor 29, a signal proportional to the energization current in phases 1, 2. When such signal exceeds a prefixed threshold, output signal E, normally at logical level 0, rises to logical level 1 for a predetermined time interval and therefore switches off that one of two transistors 5, 6 which was switched on.

In similar way control circuit 24 receives on its input, connected to a terminal of resistor 39, a signal proportional to the energization current in phases 3, 4. When such signal exceeds a prefixed threshold, equal to that of circuit 23, output signal F, normally at logical level 0, rises to logical level 1 for a predetermined time interval, equal to that one of circuit 23, and therefore switches off that one of two transistors 7, 8 which was switched on.

It is to be noted that the frequency of control signals E and F, that is the chopping frequency of the drive circuit, is widely higher than the one of command signals A, B, C, D.

A detailed description of a preferred embodiment for control circuits 23 and 24 is provided by European Patent Application No. 81110225.0, EP—A—54826. A circuit, which allows to reduce the transistor storage time during the switching from ON to OF, is associated to each one of transistors 5, 6, 7, 8.

Referring for instance to transistor 5; such circuit comprises a capacitor 25, a diode 45 and a resistor 35.

A terminal of capacitor 25 is connected to the collector of transistor 6, to the cathode of diode 11 and to terminal of the winding magnetically coupled to the one associated to transistor 5 (that is winding 1).

The other terminal of capacitor 25 is connected to the cathode of diode 45 and to terminal of resistor 35.

The second terminal of resistor 35 is connected to voltage source $+V_1$ and the anode of diode 45 is connected to the base of switching transistor 5.

The circuits reducing the storage times of transistors 6, 7, 8 are formed in similar way.

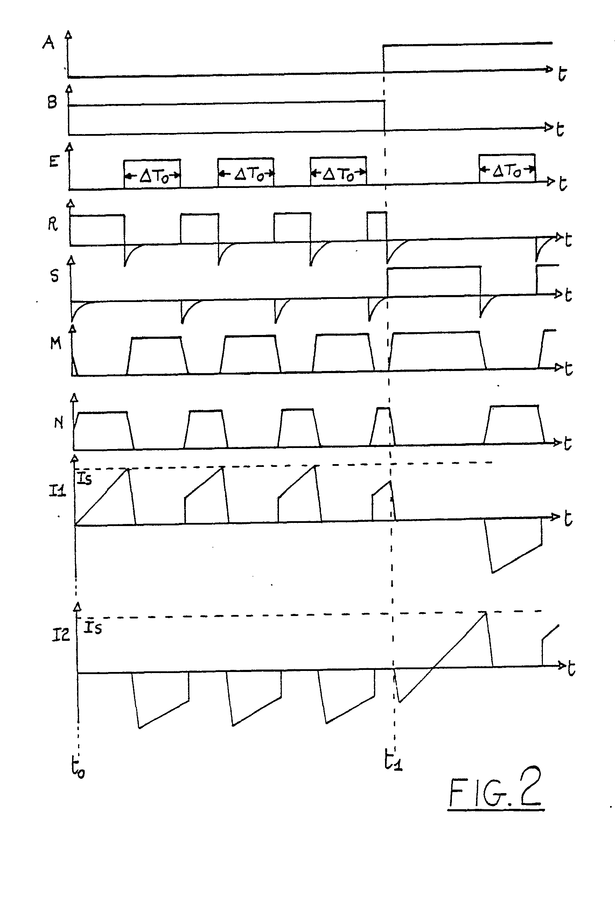

Particularly capacitor 26, diode 46 and resistor 36 form the circuit associated to transistor 6; capacitor 27, diode 47 and resistor 37 form the circuit associated to transistor 7; capacitor 28, diode 48 and resistor 38 form the circuit associated to transistor 8. In order to point out the action performed by the circuits reducing the storage times of transistors 5, 6, 7, 8, it needs to refer to the pair of windings 1, 2 of fig. 1 and to fig. 2 which shows the wave forms in particular points of drive circuit of fig. 1.

The analysis of the circuits associated to windings 3, 4 is completely similar to the one which will be made for the circuits associated to windings 1, 2.

In fig. 2 diagrams A, B, shows the level of control signals A, B; diagram E show the level of control signal E; diagram R, S show the level of the signals present on the output of the NOR gates 14, 15 respectively; diagrams M, N show the voltage present at the collectors of transistors 5, 6 respectively; diagrams l1, l2 show the currents flowing through windings 1, 2 respectively.

At rest, that is when energization commands A, B are inactive (at logical level 1), the outputs of NOR gates 14, 15 are virtually connected to ground, that is R and S are substantially at zero voltage level and transistors 5 and 6 are cutoff. In such situation currents l1 and l2 are null (therefore the current crossing resistor 29 is null and E is at logical level 0), points M and N are at potential $+V$, capacitors 25 and 26 are subjected to a positive voltage (with reference to the polarity shown in fig. 1) equal to $V-V_1$ and diodes 45, 46 are biased in the reverse direction.

It is supposed that phase winding 1 is energized at a time $t_o$, that is signal A falls to logical level 0 at time $t_o$ (diagram A of fig. 2). Therefore signal R rises to logical level 1 and, because NOR gate 14 is of "open collector" type, the base of transistor 5 results connected to voltage source $+V_1$ through resistor 18. It is to be noted that, in such situation, the voltage level of signal R present on the base of transistor 5 must be lower than voltage $+V_1$ so that diode 45 remains biased in reverse direction.

As soon as transistor 5 is saturated, point M falls to ground potential. Owing to the high magnetic coupling between windings 1 and 2, voltage change $+V$ on point M appears on point N which therefore moves to potential $+2V$; it follows that capacitor 25 is subjected to a positive voltage (with reference to the polarity shown in fig. 1) which reaches a value equal to $2V-V_1$ with a time constant proportional to the capacitance of capacitor 25 and to the resistance of resistor 35. Potential change $+V$ on point M is transferred through capacitor 26 and diode 46 on the base of transistor 6 which is therefore subjected to a negative voltage pulse (diagram S of fig. 2).

Such pulse, which has no effect on transistor 6 because it was already cutoff, has a duration proportional to the time constant with which the voltage on capacitor 26 moves to negative value $V_1$ (with reference to the polarity shown in fig. 1).

In particular a negative voltage is present on the base of transistor 6 until the voltage on capacitor 26 reaches a positive value (with reference to the polarity shown in fig. 1) equal to 0.7 V.

When transistor 5 is saturated, an energization current is flowing through winding 1 (diagram l1 of fig. 2). When such current reaches a predetermined threshold value $I_s$, output E of control circuit 23 rises to logical level 1. So the output of NOR gate 14 falls to logical level 0 and again cuts off transistor 5.

Point M rapidly moves to voltage $+2V$ and, owing to the high magnetic coupling, point N moves nearly to ground (more precisely to $-0.7V$). Voltage change $+2V$ on point N is transferred through capacitor 25 and diode 45 on the base of transistor 5 which is therefore subjected to a negative voltage pulse (diagram R of fig. 2): for such pulse the same considerations made for the negative pulse applied to the base of transistor 6 are valid.

This voltage pulse allows to remove very rapidly the minority carriers from the base of transistor 6 and therefore allows current l1 to fall rapidly to zero.

The sudden fall to zero of current l1 causes an induced current in winding 2 (diagram l2 of fig. 2): such induced current flows from ground to voltage source $+V$ through diode 11.

After a time interval $\Delta T_o$ determined by the characteristics of control circuit 23, control signal E again falls to logical level 0 and again saturates transistor 5.

The phenomena which follow are completely similar to the previous ones, with the difference that, with respect to time $t_o$, capacitor 25 is not subjected to a negative voltage (with reference to the polarity shown in fig. 1) about equal to $V_1$ and capacitor 26 to a positive voltage (always with reference to the polarity of fig. 1) equal to $2V-V_1$. Besides, the feeding of current l1 through winding 1 occurs when a recycle current l2 is still present in winding 2, so that it is initially limited by the only leakage inductance of the windings and by the resistance of winding 1.

Therefore a fast increase of current l1 is initially

obtained, such increase being contemporaneous with the fast drop to zero of current I2.

Afterwards current I1 increases with a rate limited by the characteristic inductance of winding 1 and by the resistance of it.

It is important to be noted that, during the energization of phase winding 1, the length of negative voltage pulse on the base of transistor 5 must be shorter than the time interval $\Delta$To. In fact, in contrary case, it may happen that diode 45 is still biased in forward direction when signal R rises to logical level 1: in such conditions signal R might not saturate transistor 5. A similar remark is valid for the length of the negative voltage pulse on the base of transistor 6. It is interesting to consider what happens when a phase switching is commanded.

For such purpose it is supposed that, at time $t_1$ (fig. 2), A rises to logical level 1 and at the same time B falls to logical level 0. In such case, supposing E at logical level 0 (if E were at logical level 1, it would fall to logical level 0 at the most with a delay equal to $\Delta$To), R falls to logical level 0 and cuts off transistor 5, whilst S rises to logical level 1 and saturates transistor 6.

Point N rapidly moves from voltage +2V to a voltage about 0, whilst point M rapidly moves from a voltage about 0 to voltage +2V. Also in such case the voltage change on point N is transferred through capacitor 25 and diode 45 to the base of transistor 5: the resulting negative voltage pulse allows current I1 to fall rapidly to 0. It is to be noted that current I2 is now given by two components: one due to the induced current flowing from ground to voltage source +V through diode 11, the other one due to the magnetizing current flowing from voltage source +V to ground through transistor 6 and resistor 29. Next to the phase switching, current I2 has therefore the slope shown in fig. 2.

The analysis for the times following $t_1$ is then completely similar to the already made one.

At this point it can be understood why in the drive circuit of the invention, where the stepping motor is commanded by energizing suitably pairs of phase windings, two separate current control circuits 23, 24 have been used.

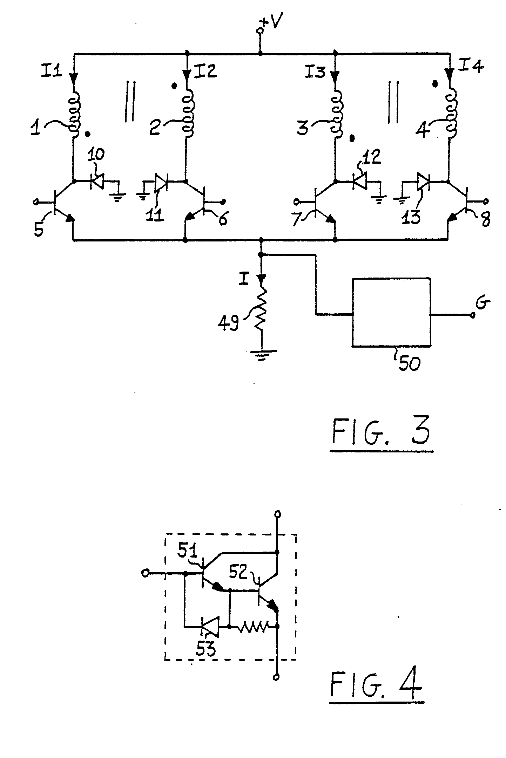

For such purpose fig. 3 shows a simplified drive circuit similar to the one of fig. 1. The drive circuit of fig. 3 uses an only resistor 49 connecting to ground the emitters of transistors 5, 6, 7, 8 and an only current control circuit 50.

It is supposed that initially phase windings 1, 3 are energized. Current I flowing through resistor 49 will be the sum of currents I1, I3 which are supposed equal.

When I1+I3=I1s (where I1s is the current threshold which makes control circuit 50 commutate and is equal to 2Is, that is twice the current threshold of circuits 23, 24 of fig. 1), output signal G of circuit 50 rises from logical level 0 to logical level 1, so that current I is interrupted and may begin flowing again after a time interval $\Delta$To determined by circuit 50.

It is now supposed that, after the couple of windings 1, 3, the couple of windings 2, 3 is energized.

The current through resistor 49 is then I=I2+I3.

However remembering what befalls current I2 during the switching from phase 1 to phase 2 (diagram I2 of fig. 2), threshold value I1s is reached with a current I3 greater than current I2.

This causes a current unbalance in the phase windings.

Such unbalance, besides causing a rotor positioning error next to the prefixed stable positions, also causes a degradation of the torque. The use of fig. 1 of resistors 29, 39 and of control circuits 23, 24 avoids these disadvantages.

It is clear that, if the stepping motor is commanded by energizing only one phase winding at a time, it is possible and economically preferable to use the drive circuit of fig. 3.

Several modifications may be made to the described drive circuit without departing from the scope of the invention.

In particular Darlington circuits may be used as switching transistors, as long as such Darlington circuits are provided with means able to speed up the switching from ON to OFF of the output transistor.

For such purpose fig. 4 shows a Darlington circuit (circuit manufactured by Texas with code BU180) where a diode 53 is put between the bases of two transistors 51, 52 (the anode of diode 53 is connected to base of output transistor 52).

It is clear that in such case a negative voltage pulse applied to the control input of Darlington circuit will remove very rapidly the minority carriers from both the base of drive transistor 51 and the base of output transistor 52.

Besides, although figs. 1, 3 show circuits using NPN transistors, it is clear that, through obvious polarity changes, PNP transistors can be used.

**Claims**

1) Step motor drive circuit wherein the phase windings (1, 2, 3, 4) of the motor are magnetically coupled in pairs 1, 2 and 3, 4 and wherein each of the phase windings is energized by switching on a related switching device (5, 6, 7, 8), said drive circuit comprising current chopping control means (23, 24) providing the switching device related to the energized phase winding with a control signal which allow the energizing current to flow intermittently in said device, characterized by that it comprises circuit means including

— a capacitor (25, 26, 27, 28) having a first terminal connected to a terminal of the phase winding magnetically coupled to the one associated to said switching device;

— a diode (45, 46, 47, 48) having the anode connected to the control input of said switching device;

— a resistor (35, 36, 37, 38) connected between the cathode of said diode and a DC voltage source;

said circuit means being associated with each switching device, said circuit means (45, 25; 46, 26; 47, 27; 48, 28) coupling the control input of said switching device and a terminal of the phase winding magnetically coupled to the phase winding associated to said switch device, said circuit means applying to said switch device the voltage pulse appearing at said terminal when said switching device is controlled to change from the switching on state to the switching off state, said pulse speeding up the response time of said switching device.

2. Stepping motor drive circuit as claimed in claim 1 wherein said switching device is constituted by a pair (51, 52) of transistors in Darlington configuration, the bases of said transistors being connected together through a diode (53).

**Patentansprüche**

1. Steuerschaltung für Schrittmotoren, wobei die Phasenwirklungen (1, 2, 3, 4) des Motors paarweise (1, 2 und 3, 4) magnetisch gekoppelt sind, jede Phasenwirklung durch Einschalten einer zugeordneten Schalteinrichtung (5, 6, 7, 8) mit Strom versorgt wird un die Steuerschaltung eine Stromimpulssteuerung (23, 24) aufweist, welche der der eingeschalteten Phasenwicklung zugeordneten Schalteinrichtung ein Steuersignal zuführt, welches einen intermittierenden Stromfluß durch die Schalteinrichtung ermöglicht, dadurch gekennzeichnet, daß die Steuerschaltung jeder Schalteinrichtung zugeordnet jeweils einen Schaltkreis aufweist, der

— einen Kondensator (25, 26, 27, 28) enthält, dessen einer Anschluß mit einem Anschluß derjenigen Phasenwicklung verbunden ist, welche mit der der betreffenden Schalteinrichtung zugeordneten Phasenwicklung magnetisch gekoppelt ist;
— eine Diode (45, 46, 47, 48) umfaßt, deren Anode an den Steuereingang der betreffenden Schalteinrichtung angeschlossen ist;
— einen Widerstand (35, 36, 37, 38) enthält, der zwischen die Kathode der Diode und eine Gleichstromquelle eingeschaltet ist;

daß der Schaltkreis (45, 25; 46, 26; 47, 27; 48, 28) den Steuereingang der betreffenden Schalteinrichtung mit einem Anschluß derjenigen Phasenwicklung verbindet, die mit der der betreffenden Schalteinrichtung zugeordneten Phasenwicklung magnetisch gekoppelt ist; und daß der Schaltkreis der Schalteinrichtung den Spannungsimpuls zuleitet, der am genannten Anschluß auftritt, wenn die Schalteinrichtung vom durchgeschalteten in den gesperrten Zustand umgesteuert wird, wobei dieser Impuls die Ansprechzeit der Schalteinrichtung verkürzt.

2. Schrittmotorsteuerschaltung nach Anspruch 1, dadurch gekennzeichnet, daß die Schalteinrichtung aus einem Transistorpaar (51, 52) in Darlingtonschaltung besteht und die Basiselektroden beider Transistoren über eine Diode (53) miteinander verbunden sind.

**Revendications**

1. Circuit de commande pour moteur pas à pas dans lequel les enroulements de phase (1, 2, 3, 4) du moteur sont couplés magnétiquement par paires (1, 2 et 3, 4) et dans lequel chacun des enroulements de phase est excité par la mise à l'état conducteur d'un dispositif de commutation correspondant (5, 6, 7, 8), le circuit de commande comprenant des moyens de contrôle d'interruption de courant (23, 24) fournissant au dispositif de commutation correspondant à l'enroulement de phase excité un signal de commande qui permet au courant d'excitation de traverser de façon intermittente ledit dispositif, caractérisé en ce qu'il comprend un circuit incluant un condensateur (25, 26, 27, 28) ayant une première borne connectée à une borne de l'enroulement de phase couplé magnétiquement à celui qui est associé au dispositif de commutation, une diode (45, 46, 47, 48) dont l'anode est connectée à l'entrée de commande du dispositif de commutation et une résistance (35, 36, 37, 38) connectée entre la cathode de la diode et une source de tension en courant continu, ledit circuit étant associé à chaque dispositif de commutation, ce circuit (45, 25; 46, 26, 47, 27; 48, 28) reliant l'entrée de commande du dispositif de commutation et une borne de l'enroulement de phase couplé magnétiquement à l'enroulement de phase associé au dispositif de commutation, ce circuit appliquant au dispositif de commutation l'impulsion de tension apparaissant à ladite borne quand le dispositif de commutation est commandé pour passer de l'état conducteur à l'état bloqué, l'impulsion accélérant le temps de réponse du dispositif de commutation.

2. Circuit de commande pour moteur pas à pas selon la revendication 1, caractérisé en ce que le dispositif de commutation est constitué d'une paire de transistors (51, 52) dans une configuration de Darlington, les bases des transistors étant connectées ensemble par l'intermédiaire d'une diode (53).

FIG. 1

0 068 306

FIG.2

0 068 306

2

FIG. 3

FIG. 4